# EUROPEAN PATENT APPLICATION

(11) **EP 4 852 323 A1**
(43) Date of publication of application: **09.12.2026**
(21) Application number: 25181473.7
(22) Date of filing: 06.06.2025
(51) Int. Cl.: H03K 17/06

(54) **METHOD OF DRIVING A TRANSISTOR**

(71) Applicant: Infineon Technologies Austria AG, 9500 Villach (AT)
(72) Inventor: FERIANZ, Thomas, 9551 Bodensdorf (AT); AZURZA ANDERSON, Jon, 9500 Villach (AT); ABDEL-RAHMAN, Osama, Orlando, 32828 (US); SANDERS, Anthony, 85622 Weißenfeld (DE)
(74) Representative: Infineon Patent Department

(57) **Abstract**

A driver circuit is presented. The driver circuit may be configured to receive a feedback signal from a transistor and to apply a drive current to a gate of the transistor. The feedback signal may be indicative of at least one of a drain current of the transistor, a source current of the transistor, and a drain voltage of the transistor. The driver circuit may be configured to adapt the drive current based on the feedback signal received from the transistor. The driver circuit may be configured to increase the drive current when the feedback signal increases, and decrease the drive current when the feedback signal decreases. By increasing and decreasing the drive current, a saturation current of the transistor may be increased and decreased as needed, and the power efficiency of the driver circuit may be improved.

## Description

### Technical field

The present document relates to methods of driving transistors and corresponding driver circuits. In particular, the present document relates to driver circuits for gallium nitride (GaN) gate injection transistors (GIT).

### Background

With their superior switching speed, GaN transistors enable high power density, reduce energy losses, and increase efficiency in a wide range of applications. As a result, power converters comprising GaN transistors are expected to be smaller and lighter systems delivering high performance. To utilize the full potential of GaN transistors, a careful design of the driver circuit is inevitable.

### Summary

According to an aspect, a driver circuit is presented. The driver circuit may be configured to receive a feedback signal from a transistor and to apply a drive current to a gate of the transistor. The driver circuit may be configured to adapt the drive current based on the feedback signal received from the transistor. To be more precise, the driver circuit may be configured to change a value of the drive current over time based on a value of the feedback signal. The feedback signal may be a voltage, a current, or a combination of both. The driver circuit may be configured to operate the transistor as a switch which is either turned on (i.e. closed) or turned off (i.e. open).

The feedback signal may be indicative of a load current flowing through the transistor. Specifically, the feedback signal may be indicative of the load current flowing through the transistor when the transistor is turned on. Thus, it may become possible to adapt the drive current to the load situation of the transistor and thereby reduce losses. In particular, losses within the driver circuit associated with the generation of the drive current may be reduced.

The feedback signal may be indicative of at least one of a drain current of the transistor, a source current of the transistor, and a drain voltage of the transistor. For example, the drain voltage may be indicative of a drain-source voltage of the transistor.

The driver circuit may be configured to increase the drive current when the feedback signal increases. That is, the driver circuit may be configured to increase the drive current when the drain current, the source current or the drain voltage increases. Vice versa, the driver circuit may be configured to decrease the drive current when the feedback signal decreases. That is, the driver circuit may be configured to decrease the drive current when the drain current, the source current or the drain voltage decreases.

By increasing and decreasing the drive current applied to the gate to the transistor, a saturation current of the transistor may be increased and decreased correspondingly. As a result, the driver circuit may be capable of increasing the drive current only during time intervals during which a higher saturation current is required for supporting a high load current of the transistor. An overdrive situation during such time intervals may however be limited to said time intervals, which may be comparatively short. After the load current has decreased again, the driver circuit may return to a more power efficient low drive current.

The driver circuit may be configured to adapt the drive current such that the drive current is direct proportional to the feedback signal. In other words, the driver circuit may be configured to adapt the drive current such that the driver current and the feedback are in a linear relationship.

The driver circuit may be configured to receive a control signal for turning on and off the transistor, to generate a drive voltage based on the control signal, and to apply both the drive voltage and the drive current to the gate of the transistor. The control signal may be e.g. a pulse width modulation (PWM) signal. The driver circuit may be configured to apply the drive current to the gate of the transistor if the control signal indicates that the transistor shall be turned on. In particular, the driver circuit may be configured to apply the drive current to the gate of the transistor only if the control signal indicates that the transistor shall be turned on. In this way, power efficiency of the driver circuit may be further improved.

The driver circuit may be configured to generate a sense current based on the feedback signal, and the driver circuit may comprise a current mirror configured to mirror the sense current into the drive current.

The driver circuit may further comprise a current sense terminal, and the current mirror may be configured to mirror the sense current into an output sense current. Said output sense current may be provided at said current sense terminal.

The current mirror may comprise a first mirror ratio for scaling the drive current relative to the sense current. In this way, a linear relationship between the sense current and the drive current may be established. Moreover, the current mirror may comprise a second mirror ratio for scaling the output sense current relative to the sense current. The first mirror ratio may be different from the second mirror ratio.

The output sense current provided at the current sense terminal may be used by an external controller as an indication of the present load of the transistor. More specifically, the output sense current may be used as an indication of the drain current or the source current flowing through the transistor. For this purpose, an external resistor may be coupled to the current sense terminal for translating said output sense current into a voltage which is then provided to the external controller. Since, for many applications, this output sense current has to be provided anyway by the driver circuit, the existing sense method may be re-used for generating said driver current for driving the gate of the transistor. To this end, only one additional leg may be added to the existing current mirror for mirroring out the drive current. In other words, the current mirror may comprise a first leg through which the sense current flows, a second leg for mirroring out the output sense current, and a third leg for mirroring out the drive current. In the above-described scenario, the feedback signal may be indicative of the drain current or the source current of the transistor.

Alternatively or additionally, the feedback signal may be indicative of the drain voltage of the transistor. The driver circuit may comprise a voltage controlled current source configured to translate the feedback signal into said sense current. For example, the driver circuit may be coupled to the drain of the transistor and the feedback signal may be a voltage indicative of the drain voltage of the transistor or may be the actual drain voltage of the transistor. The voltage controlled current source may be e.g. a MOSFET in linear mode, i.e. a MOSFET operating in its saturation region. The voltage indicative of the drain voltage or the actual drain voltage may then be applied to the gate of the MOSFET, and the current across the drain-source channel of the MOSFET may represent the sense current.

The driver circuit may be configured to receive, as the feedback signal, a part of the drain current of the transistor. The driver circuit may be configured to generate the drive current based on said part of the drain current of the transistor. The driver circuit may comprise an input pin configured to receive said part of the drain current and an output pin configured to apply the drive current to the gate of the transistor. Within this document, a pin is referred to as an electrical contact which may be accessible from outside of the driver circuit. By using part of the drain current as the drive current, the efficiency of the driver circuit may be further improved.

The driver circuit may comprise a directional conducting element coupled between the input pin and the output pin. The directional conducting element may be configured to enable current flow from the input pin to the output pin (with a low resistance, ideally zero), and may be configured to prevent current flow in the opposite direction (with a high resistance, ideally infinite). For instance, the directional conducting element may be a Schottky diode, a diode-connected transistor or any other type of diode. The driver circuit may comprise a current limiting resistor coupled between the input pin and the output pin.

The driver circuit may comprise a coupling transistor configured to establish an electrical connection between the input pin and the output pin. More specifically, the coupling transistor may be configured to, when turned on, establish the electrical connection between the input pin and the output pin. The coupling transistor may be configured to, when turned off, isolate the input pin from the output pin. A source of the coupling transistor may be coupled to the input pin, and a drain of the coupling transistor may be coupled to the output pin. The coupling transistor may be e.g. a MOSFET.

The driver circuit may comprise an operational amplifier, wherein a non-inverting input of the operational amplifier may be coupled to the input pin, an inverting input of the operational amplifier may be coupled to the output pin, and an output of the operational amplifier may be coupled to a gate of the coupling transistor.

According to another aspect, a system comprising the above-described driver circuit is presented. The system may also comprise the transistor. For instance, the transistor may be implemented using a III-V compound semiconductor material and may be e.g. a GaN high-electron-mobility transistor (HEMT). In particular, the transistor may be a gallium nitride (GaN) gate injection transistor (GIT) comprising a gate, a source, and a drain. The drive current (also denoted as gate current) may flow into said gate. The GaN GIT may have a diode characteristic at its gate-source transition.

The driver circuit and the transistor may be integrated into a common package. The driver circuit may be implemented on a Silicon semiconductor die and the transistor may be implemented on a Gallium Nitride semiconductor die. The system may further comprise a sensing transistor implemented on said Gallium Nitride semiconductor die. The sensing transistor may be coupled between a drain of the transistor and an input pin of the driver circuit.

The sensing transistor may be configured to forward to the input pin of the driver circuit (a) a feedback signal indicative of the drain voltage of the transistor and/or (b) a feedback signal indicative of the drain current of the transistor. In the latter case, the sensing transistor may be configured to branch off a part of the drain current and direct said part of the drain current to the driver circuit. The driver circuit may be coupled to a gate of said sensing transistor, and the driver circuit may be configured to turn the sensing transistor on when the transistor is turned on. Vice versa, the driver circuit may be configured to turn the sensing transistor off when the transistor is turned off.

According to yet another aspect, a method of driving a transistor is presented. The method may comprise steps corresponding to the functional features of the driver circuit and the transistor described in the foregoing description. In particular, the method may comprise receiving a feedback signal from the transistor, adapting a drive current based on the feedback signal received from the transistor, and applying the drive current to a gate of the transistor. The feedback signal may be indicative of a load current flowing through the transistor. The feedback signal may be indicative of at least one of a drain current of the transistor, a source current of the transistor, and a drain voltage of the transistor.

The method may further comprise increasing the drive current when the feedback signal increases. The method may further comprise adapting the drive current such that the drive current is direct proportional to the feedback signal. The method may further comprise receiving a control signal for turning on and off the transistor, generating a drive voltage based on the control signal, and applying both the drive voltage and the drive current to the gate of the transistor. The method may further comprise applying the drive current to the gate of the transistor if the control signal indicates that the transistor shall be turned on.

The method may further comprise generating a sense current based on the feedback signal, and mirroring the sense current into the drive current. The method may further comprise mirroring the sense current into an output sense current and providing said output sense current at a current sense terminal of a driver circuit. In this scenario, the feedback signal may be indicative of the drain current or the source current of the transistor.

If, however, the feedback signal is indicative of the drain voltage of the transistor, the method may further comprise translating, by a voltage controlled current source, the feedback signal into said sense current.

The method may further comprise receiving, as the feedback signal, a part of the drain current of the transistor, generating the drive current based on said part of the drain current of the transistor, receiving said part of the drain current at an input pin of a driver circuit, and applying the drive current to the gate of the transistor via an output pin of the driver circuit. The method may further comprise coupling a directional conducting element between the input pin and the output pin. The method may further comprise coupling a current limiting resistor between the input pin and the output pin.

The method may further comprise establishing an electrical connection between the input pin and the output pin using a coupling transistor. The driver circuit may further comprise an operational amplifier, wherein a non-inverting input of the operational amplifier is coupled to the input pin, an inverting input of the operational amplifier is coupled to the output pin, and an output of the operational amplifier is coupled to a gate of the coupling transistor.

The method may comprise forwarding, by a sensing transistor, a feedback signal indicative of the drain voltage of the transistor to the input pin of the driver circuit. The method may comprise forwarding, by the sensing transistor, a feedback signal indicative of the drain current of the transistor to the input pin of the driver circuit. The method may further comprise branching off a part of the drain current of the transistor. For this purpose, a sensing transistor may be coupled to the drain of the transistor. The method may comprise directing, by the sensing transistor, the part of the drain current to the driver circuit. The method may comprise turning on the sensing transistor (only) if the transistor is turned on.

It should be noted that the methods and systems including its preferred embodiments as outlined in the present document may be used stand-alone or in combination with the other methods and systems disclosed in this document. In addition, the features outlined in the context of a system are also applicable to a corresponding method. Furthermore, all aspects of the methods and systems outlined in the present document may be arbitrarily combined. In particular, the features of the claims may be combined with one another in an arbitrary manner.

The expression "and/or" should be interpreted to cover all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B. In particular, the expression "at least one of A, B, and C" should be interpreted to mean A but not B and not C, B but not A and not C, C but not A and not B, A and B but not C, A and C but not B, B and C but not A, or the combination of A, B, and C.

In the present document, the term "couple" or "coupled" refers to elements being in electrical communication with each other, whether directly connected e.g., via wires, or indirectly connected via other circuit elements between them. For example, two elements may be said to be coupled even if there is a circuit element such as a switch (which may be turned on and off) in between them. On the other hand, the term "connect" or "connected" refers to elements being directly electrically connected with each other, e.g. via wires, and no circuit elements are located between them.

### Short description of the figures

The present invention is illustrated by way of example, and not by way of limitation, in the figures in which like reference numerals refer to similar or identical elements, and in which
Fig. 1 shows typical GaN saturation current characteristics,
Fig. 2 shows a first exemplary system with a driver circuit and a transistor,
Fig. 3 shows a second exemplary system with a driver circuit and a transistor,
Fig. 4 shows a third exemplary system with a driver circuit and a transistor, and
Fig. 5 shows a fourth exemplary system with a driver circuit and a transistor,

### Detailed Description

Unlike other technologies, like Silicon and Silicon Carbide (SiC), whose current conduction limitation is typically given by the thermal capacitance of the device, GaN devices have an intrinsic current conducting capability limitation, i.e., current saturation, in their conduction region (two-dimensional electron gas, 2DEG).

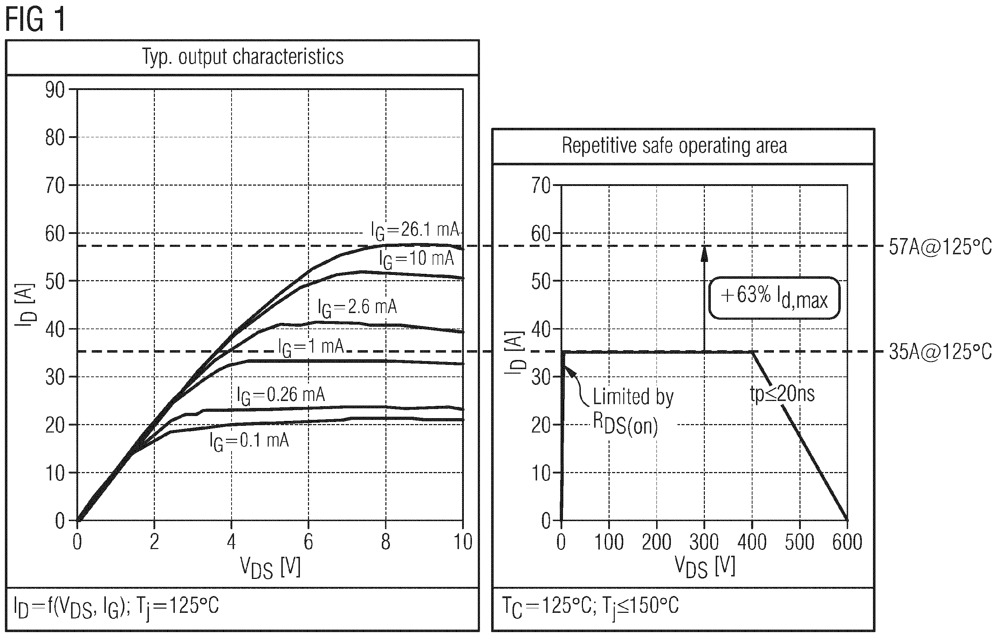

Coming to the GaN more in detail, there are two limitations to the saturation current that are present and that are illustrated in Fig. 1. On the one hand, the output characteristic is shown in the left diagram. The output characteristic is measured "statically", in the sense that the device is not blocking high voltage before, and its turn-on can be considered soft. On the other hand, the repetitive safe operating is shown in the right diagram. The repetitive safe operating area is measured "dynamically" in a double pulse test, and it results after a hard turn-on. It should be mentioned that the repetitive safe operating in the right diagram is illustrated at a gate current of 26.1mA.

As it can be seen in Fig. 1, the current saturation is limited (or enhanced) by the gate current I_{G}. The higher the gate current I_{G}, the higher the saturation current, both static and dynamic.

Saturation current in GaN devices is of great importance as it may limit the output power if the saturation current is too low. One can try to mitigate this effect by driving a GaN device with a higher gate current I_{G}. However, the disadvantage of driving the device always with the highest allowed I_{G} is that the driving losses become very high, and there might be no need to drive the device always with the highest I_{G}.

For instance, if one has a soft switching device and wants to reach a drain current I_{D}~30A for the example of Fig. 1, it is sufficient to drive the device with gate current I_{G} = 1mA. However, if there is an event in the lifetime that only occurs rarely, but can make the drain current reach I_{D}~45A, then the device has to always be turned on with a sufficiently high gate current of I_{G} = 10mA, which is an order of magnitude higher gate current. Hence, also the losses might be an order of magnitude higher than needed.

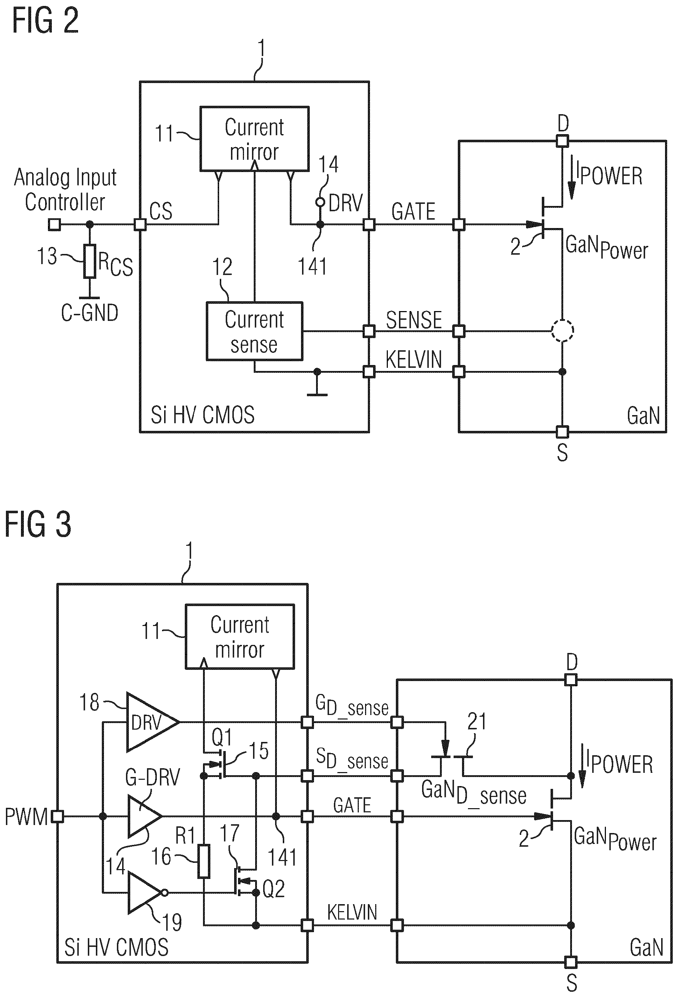

Fig. 2 shows a first exemplary system with a driver circuit 1 and a transistor 2. The driver circuit 1 uses a current sense method, e.g., a Kilis cell or finger, connected to the source side of the transistor, and that current sense signal is then fed into a current mirror 11 which accordingly adapts the strength of the gate current I_{G} (also denoted as drive current) to drive the GaN transistor 2. This method may re-use existing current sense methods which are already implemented in various products. In other words, in Fig. 2, the current sense unit 12 generates a sense current based on a feedback signal indicative of the source current of the transistor 2. The current mirror 11 is then mirroring said sense current to a current sense terminal denoted as CS. An external resistor 13 may be connected to the current sense terminal for translating the output sense current into an output sense voltage. An external controller (not shown) may read the output sense voltage. At the same time, current mirror 11 may generate a second mirror current (the drive current) which is subsequently applied to the gate of the transistor 2. At injection point 141, said drive current is injected and combined with the output of gate driver 14. As will be described and illustrated in Fig. 3, the gate driver 14 (denoted as DRV) receives a PWM signal for controlling the transistor 2 and amplifies this PWM signal for driving the transistor.

Fig. 3 shows a second exemplary system with a driver circuit 1 and a transistor 2. Here, a similar implementation of gate current I_{G} adaptation is shown, but instead of using a current sense type measurement, an on-state voltage measurement of the whole transistor (and not a single finger, as Fig. 2) is used. For this, a small GaN sensing transistor 21 is used to interface to the main transistor 2. The GaN sensing transistor 21 may be a high voltage rated transistor.

In particular, the sensing transistor 21, which may be also implemented on the same Gallium Nitride semiconductor die, is coupled between a drain of the transistor 2 and a gate of transistor 15 (voltage controlled current source). Transistor 15 then translate the drain voltage of the transistor 2 into a corresponding sense current. In addition to transistor 15, a resistor 16 may be coupled between the current mirror 11 and the Kelvin terminal. The sense current is mirrored into the drive current and fed back to the gate of transistor 2 as described for Fig. 2. In particular, the drive current is injected into injection point 141 which is again located at the output of gate driver 14. It should be mentioned that current mirror 11 could also have a second output (not shown) as in Fig. 2 for outputting an output sense current to a current sense terminal CS.

The driver circuit 1 may turn the sensing transistor 21 on only when needed, i.e. only when the transistor 2 is turned on, too. To this end, the driver circuit 1 comprises a special driver circuit 18 designed to drive the sensing transistor 21, and this special driver circuit 18 is controlled by the same PWM signal as transistor 2.

Optionally, the driver circuit 1 may comprise a pulldown transistor 17 coupled between the gate of transistor 15 and the Kelvin terminal. Pulldown transistor 17 is turned on whenever main transistor 2 is turned off. For this purpose, transistor 17 is driven by an inverting driver circuit 19 which is configured to invert and amplify the PWM signal.

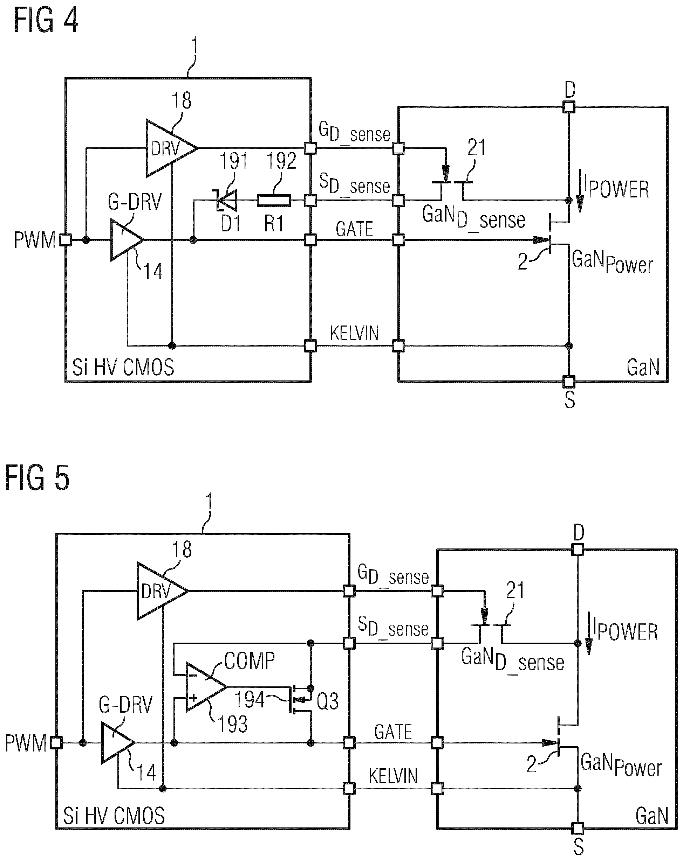

Fig. 4 shows a third exemplary system with a driver circuit 1 and a transistor 2. In Fig. 4, sensing transistor 21 branches off a part of the drain current of transistor 2 and redirects/reuses it for driving the gate of transistor 2. The driver circuit comprises a Schottky diode 191 (directional conducting element) coupled between the sensing transistor 21 and the gate of transistor 2. The exemplary driver circuit 1 also comprises a current limiting resistor 192 which may be coupled in series with Schottky diode 191. As described for the forgoing examples, the driver circuit 1 comprises a special driver circuit 18 designed to drive the sensing transistor 21 and regular gate driver 14 for driving the gate of transistor 2.

Fig. 5 shows a fourth exemplary system with a driver circuit 1 and a transistor 2. In Fig. 5, again a part of the drain current of the transistor 2 is used as feedback signal for driving the gate of the transistor 2. The driver circuit comprises coupling transistor 194 for establishing an electrical connection and forwarding the branched off part of the drain current to the gate of transistor 2. The driver circuit 1 may also comprise an operational amplifier 193 for controlling the coupling transistor 194. A non-inverting input of the operational amplifier is coupled to the source of transistor 194, an inverting input of the operational amplifier is coupled to the drain of transistor 194, and an output of the operational amplifier is coupled to a gate of the transistor 194.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A driver circuit configured to receive a feedback signal from a transistor and to apply a drive current to a gate of the transistor, wherein the driver circuit is configured to adapt the drive current based on the feedback signal received from the transistor.

2. The driver circuit according to claim 1, wherein the feedback signal is indicative of a load current flowing through the transistor.

3. The driver circuit according to claim 1 or 2, wherein the feedback signal is indicative of at least one of a drain current of the transistor, a source current of the transistor, and a drain voltage of the transistor.

4. The driver circuit according to any one of the preceding claims, wherein the driver circuit is configured to increase the drive current when the feedback signal increases.

5. The driver circuit according to any one of the preceding claims, wherein the driver circuit is configured to adapt the drive current such that the drive current is direct proportional to the feedback signal.

6. The driver circuit according to any one of the preceding claims, wherein the driver circuit is configured to receive a control signal for turning on and off the transistor, to generate a drive voltage based on the control signal, and to apply both the drive voltage and the drive current to the gate of the transistor.

7. The driver circuit according to claim 6, wherein the driver circuit is configured to apply the drive current to the gate of the transistor if the control signal indicates that the transistor shall be turned on.

8. The driver circuit according to any one of the preceding claims, wherein the driver circuit is configured to generate a sense current based on the feedback signal, and wherein the driver circuit comprises a current mirror configured to mirror the sense current into the drive current.

9. The driver circuit according to claim 8, further comprising a current sense terminal, wherein the current mirror is further configured to mirror the sense current into an output sense current, wherein said output sense current is provided at said current sense terminal.

10. The driver circuit according to claim 8, wherein the feedback signal is indicative of the drain current or the source current of the transistor.

11. The driver circuit according to claim 8 or 9, wherein the feedback signal is indicative of the drain voltage of the transistor, wherein the driver circuit comprises a voltage controlled current source configured to translate the feedback signal into said sense current.

12. The driver circuit according to any one of claims 1 to 7, wherein the driver circuit is configured to receive, as the feedback signal, a part of the drain current of the transistor, wherein the driver circuit is configured to generate the drive current based on said part of the drain current of the transistor, and wherein the driver circuit comprises an input pin configured to receive said part of the drain current and an output pin configured to apply the drive current to the gate of the transistor.

13. The driver circuit according to claim 12, wherein the driver circuit comprises a directional conducting element coupled between the input pin and the output pin.

14. The driver circuit according to claim 12 or 13, wherein the driver circuit comprises a current limiting resistor coupled between the input pin and the output pin.

15. The driver circuit according to claim 12, comprising a coupling transistor configured to establish an electrical connection between the input pin and the output pin.

16. The driver circuit according to claim 15, further comprising an operational amplifier, wherein a non-inverting input of the operational amplifier is coupled to the input pin, an inverting input of the operational amplifier is coupled to the output pin, and an output of the operational amplifier is coupled to a gate of the coupling transistor.

17. A system comprising the driver circuit according to any one of the preceding claims, wherein the system also comprises the transistor.

18. The system of claim 17, wherein the driver circuit and the transistor are integrated into a common package.

19. The system of claim 17 or 18, wherein the driver circuit is implemented on a Silicon semiconductor die and the transistor is implemented on a Gallium Nitride semiconductor die.

20. The system of claim 19, further comprising a sensing transistor implemented on said Gallium Nitride semiconductor die, wherein the sensing transistor is coupled between a drain of the transistor and an input pin of the driver circuit.

21. The system of claim 20, wherein the driver circuit is coupled to a gate of said sensing transistor, and wherein the driver circuit is configured to turn the sensing transistor on when the transistor is turned on.

22. A method of driving a transistor, the method comprising receiving a feedback signal from the transistor, adapting a drive current based on the feedback signal received from the transistor, and applying the drive current to a gate of the transistor.
